# EUROPEAN PATENT SPECIFICATION

(11) **EP 2 199 427 B1**
(45) Date of publication and mention of the grant of the patent: **19.08.2015**
(21) Application number: 09015487.3
(22) Date of filing: 15.12.2009
(51) Int. Cl.: C23C 16/54, B05D 7/24, G01N 21/88, C23C 14/06, C23C 14/08, C23C 16/30, C23C 16/34, C23C 16/40

(54) **Method for producing laminate**
Verfahren zur Herstellung von Laminat
Procédé de fabrication de stratifié

(30) Priority: 16.12.2008 JP 2008319941
(43) Date of publication of application: 23.06.2010
(73) Proprietor: FUJIFILM Corporation, Tokyo 106-8620 (JP)
(72) Inventor: Takahashi, Shinsuke, Ashigarakami-gun Kanagawa 258-8577 (JP); Nishida, Hiroyuki, Ashigarakami-gun Kanagawa 258-8577 (JP); Fujinami, Tatsuya, Ashigarakami-gun Kanagawa 258-8577 (JP)
(74) Representative: Hoffmann Eitle

(56) References cited:
- EP-A1- 0 899 359
- EP-A1- 1 313 134
- EP-A1- 1 788 123
- WO-A1-99/23275
- JP-A- 2006 208 184
- US-A- 4 720 437
- US-A- 5 681 651

## Description

### BACKGROUND OF THE INVENTION

### Field of the Invention

The presently disclosed subject matter relates to a method for producing a laminate. More specifically, the presently disclosed subject matter relates to a method for producing a laminate in which a plurality of thin films composed of organic films and inorganic films are formed on a flexible support.

### Description of the Related Art

Various functional films (functional sheets) such as gas barrier films, protective films and optical films such as optical filters and anti-reflection films are used in various devices such as optical elements, displays such as liquid crystal displays and organic electroluminescent displays, semiconductor devices and thin film solar batteries.

To produce such functional films, film forming (thin film forming) by a vacuum film forming method such as sputtering or plasma CVD (Chemical Vacuum Deposition) is used.

For efficient and highly productive film forming by a vacuum film forming method, continuous film forming on a long substrate is preferred.

As a facility used for such film forming methods, the so-called roll-to-roll film forming apparatus is known, in which a feeding roll on which a long substrate (web substrate) is wound and a winding roll for winding up the substrate on which film is formed, in the form of a roll are used. In such a roll to roll film forming apparatus, a long substrate is inserted and passed from the feeding roll to the winding roll in a pre-determined route including a film forming chamber where a film is formed on the substrate by plasma CVD, and while feeding the substrate from the feeding roll and winding the substrate on which film is formed on the winding roll simultaneously, film is continuously formed on the running substrate in the film forming chamber.

Films formed in this way have fine defects on the surface, and to detect such fine defects, a method of measuring and detecting scattering light caused by a defect is employed. A method is disclosed in which scattering light is detected with slightly shifting the optical axis with respect to the incident angle (creating a dark field) so that the weak scattering light is not obscured by the measurement light. Since defects have recently become finer and the scattering light is weaker, various measures are taken to deal with noise.

For example, Japanese Patent Application Laid-Open No. 2000-310600 discloses a detection method in which a light from a light source is shifted by a predetermined distance from a reflection position of an optical axis of a detection device and the scattering light is detected while avoiding direct reflecting light. Also, Japanese Patent Application Laid-Open No. 2001-228094 discloses a surface inspection apparatus in which an incident angle and detection angle are optimized so as to reduce background noise. Japanese Patent Application Laid-Open No. 05-045297 discloses a foreign matter inspection apparatus for detecting foreign matters while shielding unnecessary scattering light by a photo-shield plate.

US 4 720 437 A and JP 2006 208 184 disclose, respectively, an article having a wear-resistant coating and a surface detect inspection device.

However, the inspection methods and apparatuses described in Japanese Patent Application Laid-Open Nos. 2000-310600, 2001-228094 and 05-045297 cannot successfully detect scattering light caused by fine defects intended to detect due to the scattering light caused by relatively large defects when detecting extremely fine defects on the film surface. As a result, while positive results are obtained in the inspection, in fact, fine defects are present on the film.

The presently disclosed subject matter has been made under such circumstances, and an object thereof is to provide a production process for producing a laminate with fewer defects while enabling detection of fine detects, and the laminate and a defect detection method for the laminate.

### SUMMARY OF THE INVENTION

According to the present invention, there is provided a method for producing a laminate, as recited in Claim 1 below.

According to the present invention, since a defect cover layer is formed by CVD after forming a thin film on a support, the defect cover layer can be formed even in gaps between large defects and the thin film or the like as compared to a method by sputtering. As a result, scattering light caused by large defects can be prevented and the fine defects can be effectively inspected. This makes it possible to form a good laminate with few defects. On the other hand, large defects are detected by another inspection to control quality.

According to a particular embodiment, in the method according to the present invention, the defect cover layer has the same composition as any one of the one or more layers of the thin film formed on the support.

Since a defect cover layer is formed of the same composition as that of any one of the one or more layers in the thin film, the laminate can be formed and inspected without using a material for a defect cover layer different from materials of the layers.

According to a further particular embodiment, in the method according to the present invention, the defect cover layer is 0.3 times or less as thick as the thin film.

By setting the defect cover layer to have a thickness of 30% or less of the total thickness of the thin film, the scattering light caused by large defects can be restrained, and therefore scattering light caused by fine defects can be prevented from being obscured by the scattering light caused by the large defects. Accordingly, fine defects can be effectively inspected.

In the method for forming a laminate according to the presently disclosed subject matter, a defect cover layer is formed by CVD after forming a thin film, thereby covering defects formed on the thin film with the defect cover layer. This makes it possible to shield scattering light caused by large defects and effectively measure scattering light caused by fine defects intended to detect in order to effectively detect the fine defects. This makes it possible to form a good laminate with few defects.

### BRIEF DESCRIPTION OF THE DRAWINGS

Figs. 1A and 1B illustrate laminates produced by a production method of a laminate;
Figs. 2A and 2B illustrate scattering of light in defect detection;
Fig. 3 illustrates an example of a production apparatus of a laminate;
Fig. 4 illustrates another example of the production apparatus a laminate;
Fig. 5 illustrates still another example of the production apparatus of a laminate;
Fig. 6 illustrates a film forming apparatus for forming the laminate by CCP-CVD method;
Figs. 7A to 7D explain a state of surface of the defect cover layer when the defect cover layer is dense and when it is coarse; and
Fig. 8 is a table showing results of Examples.

### DETAILED DESCRIPTION OF THE PREFERRED EMBODIMENTS

In the following, preferred embodiments of the process for producing a laminate according to the present invention will be described with reference to the attached drawings. The present invention, as claimed, will be described by the following preferred embodiments, but modifications may be made by various means without departing from the scope of the presently disclosed subject matter, and embodiments other than the present embodiments may be employed. Accordingly, all modifications within the scope of the appended claims are included in the present invention. The numerical ranges described using "to" in the specification mean that numbers before and after "to" are included in the range.

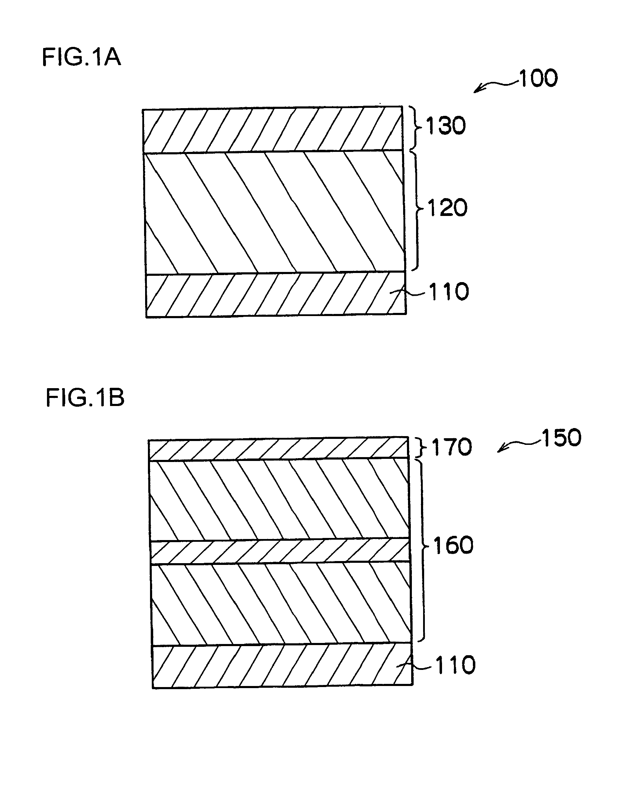

Figs. 1A and 1B are schematic views illustrating laminates produced by the production method for producing a laminate according to the presently disclosed subject matter. Fig. 1A is a schematic view of a laminate 100 having a thin film 120 of a single layer and Fig. 1B is a schematic view of a laminate 150 having a thin film 160 of three layers. As Figs. 1A and 1B show, in the production process of the presently disclosed subject matter, the laminates 100, 150 are produced by forming thin films 120, 160 on the surface of a support 110 and forming defect cover layers 130, 170 on the thin films 120, 160 by CVD, respectively.

### <Support>

In the presently disclosed subject matter, the support 110 on which the thin films 120, 160 and defect cover layers 130, 170 are formed are not particularly limited, and various resin films such as PET (polyethylene terephthalate) films and various metal sheets such as aluminum sheet may be used; supports used for various films such as gas barrier films, optical films and protective films may all be used as long as the thin film and the defect cover layer described later can be formed on them. Also, the support 110 may have a film such as a protective film or an adhesive film on the surface.

### <Thin film>

The thin film 120, 160 are formed on the surface of the support 110 and can be an organic film composed of an organic material or an inorganic film composed of an inorganic material. Fig. 1A illustrates the thin film 120 of a single layer, and the thin film 120 may be an organic film or an inorganic film. Also, as Fig. 1B shows, the thin film may have a plurality of layers, in which an organic film and an inorganic film are alternately laminated.

### [Organic film]

An organic film is composed of a polymer as a main component. Specifically, an organic film is a film composed of polyester, acrylic resin or methacrylic resin (hereinafter acrylic resin and methacrylic resin may also be collectively referred to as acrylate resin polymer) and so on.

Examples of methods of forming an organic film include a common solution coating method and a vacuum film forming method.

Examples of solution coating methods include a dip coating method, an air knife coating method, a curtain coating method, a roller coating method, a wire bar coating method, a gravure coating method, a slide coating method and an extrusion coating method using a hopper described in U.S. Patent No. 2681294. An organic layer may also be formed by applying and curing a commercially available polymerizable adhesive.

Although vacuum film forming methods are not particularly limited, film forming methods such as vapor deposition and plasma CVD are preferred. Of them, flash evaporation described in U.S. Patent Nos. 4842893, 4954371 and 5032461 are particularly preferred. Flash evaporation is particularly useful because it has an advantage of decreasing dissolved oxygen in a monomer and increasing polymerization rates.

### [Inorganic film]

The thin film formed by the production method for producing a laminate according to the presently disclosed subject matter may be formed of an inorganic film. Materials used for forming an inorganic film are not particularly limited and various inorganic films suitable for a laminate to be produced may be used.

For example, when producing a laminate as a gas barrier film (water vapor barrier film), an inorganic film of a silicon nitride film, an aluminum oxide film or a silicon dioxide film is preferably formed.

When producing a protective film for various devices and apparatuses including displays such as organic electroluminescent displays and liquid crystal displays, an inorganic film of a silicon dioxide is preferably formed.

Also, when producing an optical film such as an anti-reflection film, a light reflecting film or various filters, a film of a material which has or develops intended optical properties may be formed as an inorganic film.

When the thin film is an organic film of a single layer, the thin film has a film thickness of preferably 200 nm or more and 2000 nm or less, more preferably 300 nm or more and 1500 nm or less. When the thin film is an inorganic film of a single layer, the thin film has a film thickness of preferably 20 nm or more and 200 nm or less, more preferably 25 nm or more and 100 nm or less.

### <Defect cover layer>

The defect cover layers 130, 170 are formed by CVD and cover defects formed on a thin film, and in the later inspection step, they can block scattering lights caused by large defects when inspecting fine defects and realize efficient inspection of fine defects.

Defects formed on the thin film described above include protrusions formed on the surface of the thin film, contaminants attached to the surface of the thin film, flaws formed on the surface of the thin film and dents formed on the surface the thin film. In the inspection of such defects, the finer the defect is, the weaker the scattering light caused by the defect becomes, and therefore the scattering light is obscured by scattering light caused by a large defect, resulting in the difficulty in inspection of finer defects. Given this, by forming a defect cover layer by CVD, the scattering light caused by a large defect can be blocked and thus inspection of a fine defect becomes possible.

In the presently disclosed subject matter, a large defect means a defect having a size of 30 µm or more and 150 µm or less, and a fine defect means a defect having a size of 0.1 µm or more and 20 µm or less, preferably 0.1 µm or more and 10 µm or less, more preferably 0.1 µm or more and 3 µm or less.

The size of defect in the presently disclosed subject matter means an apparent size of defect detected by the light-receiving apparatus of the inspection apparatus described later.

As a material used for a defect cover layer, inorganic materials which can be formed into a film by CVD may be used without particular limitation; specifically, materials used when forming a thin film with an inorganic film may be used. In particular, such materials preferably have the same composition as any layer constituting the thin film. When the composition is the same as that of a layer constituting thin film, unnecessary materials need not to be mixed in the laminate formed on a support, and therefore a good laminate can be produced.

The defect cover layer is formed by a CVD method. When formed by a CVD method, a defect cover layer can be formed even in narrow gaps between a thin film and large defects formed on the thin film, and therefore scattering light caused by the large defects can be blocked (prevented) and only scattering light caused by fine defects intended to be detected can be detected; as a result, fine defects can be detected successfully and reliably at a high accuracy, making it possible to form a good laminate with few defects.

The defect cover layer is 30% or less (that is, less or equal to 0.3 times), more preferably 20% or less (that is, less or equal to 0.2 times) as thick as the thin film. Setting the thickness of the defect cover layer within the above range makes it possible to conduct good inspection. On the other hand, as for the lower limit of the thickness, a defect cover layer only needs to be thick enough to prevent scattering light caused by large defects, and the thickness is preferably 20 nm or more, and more preferably 40 nm or more.

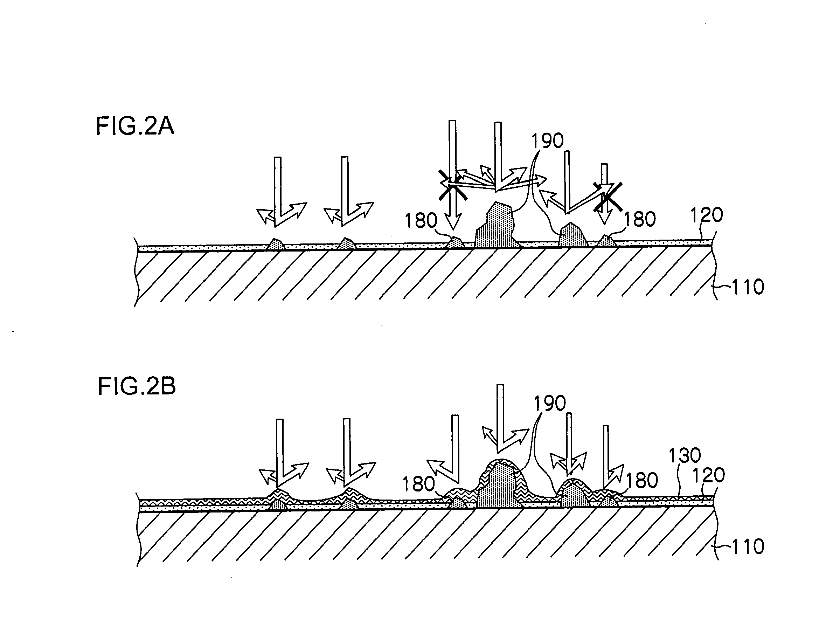

Fig. 2A is a diagram showing a laminate on which the thin film 120 is formed on the support, and Fig. 2B is a diagram showing a laminate on which the defect cover layer 130 is formed on the thin film 120.

In the laminate shown in Fig. 2A, which does not have the defect cover layer 130, since scattering light caused by a large defect 190 has high intensity, light to be used for inspecting fine defects 180 located around the large defect 190 are blocked. Therefore, the fine defects 180 located around the large defect 190 cannot be effectively inspected.

On the other hand, in the laminate shown in Fig. 2B, since the scattering light caused by the large defect 190 is suppressed by the defect cover layer 130, scattering light caused by the fine defects 180 can be detected. Accordingly, since defect inspection can be performed with high accuracy, a quality laminate with fewer defects can be produced.

### <Inspection apparatus>

An inspection apparatus inspects a laminate on which a defect cover layer is formed. An exemplary inspection apparatus is equipped with: an illumination device for irradiating light; a backup roll for converging light from the illumination device and irradiate the light; and a light-receiving device for receiving the light reflected from a laminate running on the backup roll as a contrasting signal. For example, the inspection apparatus described in Japanese Patent Application Laid-Open No. 2006-208184 may be used.

### <Process for producing laminate>

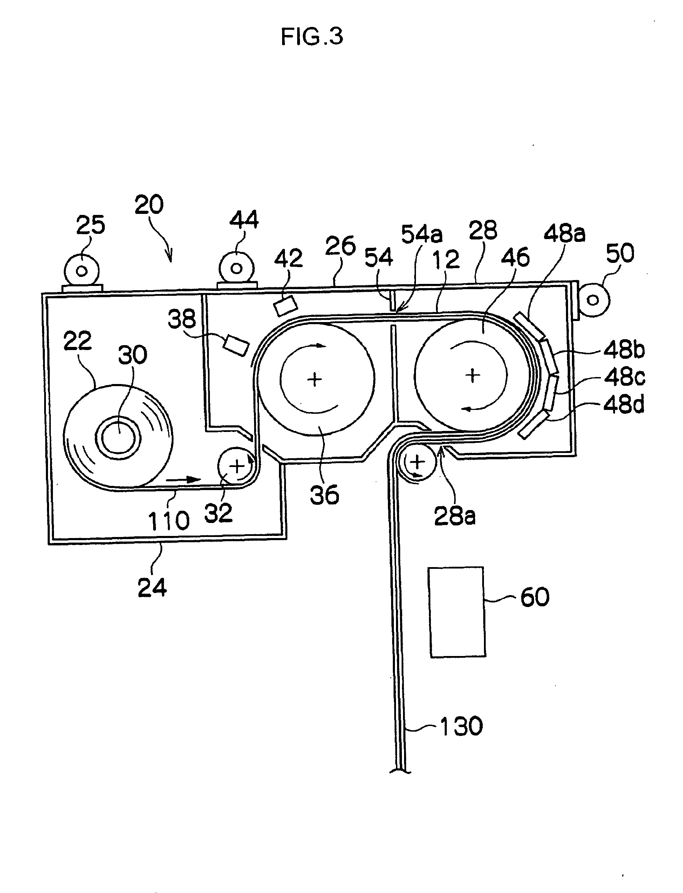

Next, the process for producing a laminate will be described. Fig. 3 schematically illustrates an example of an apparatus for producing a laminate for implementing the production method of a laminate according to the present invention.

In the laminate production apparatus 20 (hereinafter production apparatus 20) shown in Fig. 3, an organic film 12 which is a thin film composed of a predetermined polymer as a main component is formed (film formed) on the surface of a long, film-shaped support 110 (film web), and a defect cover layer 130 is formed on the organic film 12 by CVD, thereby producing a laminate as illustrated. An inspection apparatus 60 inspects defects on the resulting laminate.

In such production apparatus 20 for forming the laminate 100, the long support 110 is fed from a support roll 22 on which the support 110 is wound in the form of a roll, and while conveying the support in the longitudinal direction, the organic film 12 which is the thin film 120 and the defect cover layer 130 are formed, and then the inspection apparatus 60 inspects defects and a laminate can be produced by winding in the form of a roll. Defects may also be inspected after forming the defect cover layer 130 as shown in Fig. 3. Alternatively, inspection may be conducted after forming the defect cover layer, and once winding on a roll and feeding it again. Also, while Fig. 3 illustrates a method in which the organic film 12 is formed as the thin film 120, a method in which an inorganic film is formed instead of an organic film may be employed.

In the production apparatus 20, the support 110 is loaded on a rotational axis 30 in a support feeding chamber 24 as the support roll 22 as described above.

The support feeding chamber 24 rotates the rotational axis 30 in the counterclockwise direction in the figure by a driving source (not shown) and feeds the support 110 from the support roll 22; a guide roller 32 guides the support 110 through a pre-determined route and conveys the support 110 to an organic film forming chamber 26.

In addition to the above members, a pair of conveyance rolls or a guiding member for conveying the support 110 through a pre-determined route may be disposed in the support feeding chamber 24.

The support feeding chamber 24 is a vacuum chamber and is evacuated to a pre-determined pressure (degree of vacuum) by a vacuum pumping device 25. In the production apparatus 20, this prevents the pressure in the support feeding chamber 24 from adversely affecting the film forming of an organic film in the organic film forming chamber 26 described later.

The support 110 fed from the support feeding chamber 24 is conveyed to the organic film forming chamber 26.

The organic film forming chamber 26 is a vacuum chamber and is equipped with a drum 36, a monomer nozzle 38, a UV irradiation device 42 and a vacuum pumping device 44.

The drum 36 is a cylindrical member which rotates in the direction of the arrow in Fig. 3 around the centerline. The support 110 conveyed from the support feeding chamber 24 is wound on a pre-determined part of the peripheral surface of the drum 36 and conveyed through a pre-determined route while being held and guided by the drum 36, and the organic film 12 is formed thereon and the resultant is conveyed to a defect cover layer forming chamber 28 described later.

In the organic film forming chamber 26, a coating film is formed on the support 110 by flash evaporation using a coating material containing a monomer mixture previously prepared, and then the coating material of the coating film is polymerized, thereby obtaining the organic film 12.

When forming the organic film 12, the pressure in the organic film forming chamber 26 is reduced to a pre-determined pressure (degree of vacuum) by the vacuum pumping device 44. Known vacuum pumping devices may be used for the vacuum pumping device 44 similarly to a vacuum pumping device 244 in an inorganic film forming chamber 226, described later.

The monomer nozzle 38 applies previously prepared monomer to the surface of the support 110 under such reduced pressure. With this, coating film by flash evaporation is formed on the surface of the support 110.

The UV irradiation device 42 is used for irradiating the coating film formed by flash evaporation with UV light (ultraviolet light), thereby polymerizing monomers to form the organic film 12.

Light sources and irradiation energy that can be used are as described above. Also, polymerization methods of monomers are not limited to irradiation with UV shown in Fig. 3 and various methods can be used as described above.

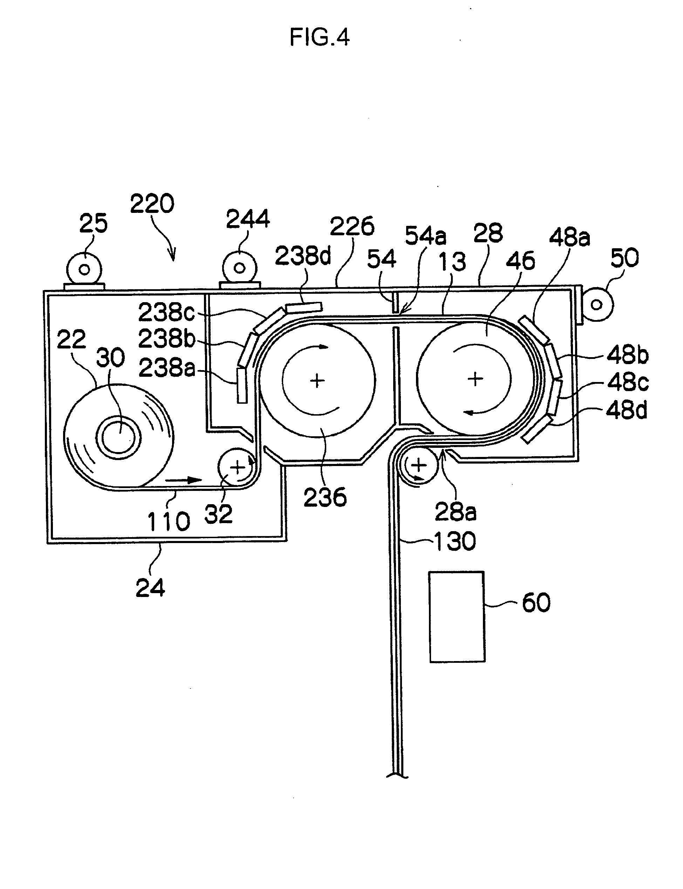

While an organic film forming chamber for forming a thin film of an organic film is described in Fig. 3, the production apparatus 220 having the inorganic film forming chamber 226 for forming a thin film of an inorganic film 13 is described in Fig. 4.

In the inorganic film forming chamber 226, the inorganic film 13 is formed on the surface of the support 110 by a vacuum film forming method, and the chamber 226 is equipped with the drum 236, film forming devices 238a, 238b, 238c and 238d, and the vacuum pumping device 244.

The inorganic film forming chamber 226 is a vacuum chamber isolated from adjacent spaces to be substantially airtight. Therefore, a slit formed on the partition wall between the chamber and the adjacent spaces preferably has a minimum size which enables the support 110 to pass therethrough without contact with the slot. In this regard, the same applies to discharge ports for discharging a film from each chamber.

When film forming is performed in the inorganic film forming chamber 226 by sputtering or plasma CVD, a high frequency power source or the like is also installed in the inorganic film forming chamber 226.

Similar to the organic film forming chamber 26, the drum 236 in the inorganic film forming chamber 226 is a cylindrical member which rotates in the direction of the arrow in Fig. 4 around the centerline.

A support conveyed from the support feeding chamber 24 is wound on a pre-determined part of the peripheral surface of the drum 236 and conveyed through a pre-determined route while being held and guided by the drum 236, and the inorganic film 13 is formed on the surface of the support by the film forming devices 238a to 238d and the like. When film forming is performed in the inorganic film forming chamber 226 by sputtering or plasma CVD, the drum 236 may be grounded (earthed) so as to act as a counter electrode as well or may be connected to a high frequency power source.

The film forming devices 238a to 238d are used for forming the inorganic film 13 on the surface of the support 110 by a vacuum film forming method.

In the production process of the presently disclosed subject matter, the method for forming the inorganic film 13 is not particularly limited and known vacuum film forming methods (vapor-phase deposition methods) such as CVD, plasma CVD, sputtering, vacuum deposition and ion plating can be used.

For that reason, the film forming devices 23 8a to 23 8d in the production apparatus 220 are equipped with various members suitable for the vacuum film forming method to be practiced.

For example, when the inorganic film is formed in the inorganic film forming chamber 226 by an ICP-CVD method (inductively coupled plasma CVD), the film forming devices 23 8a to 23 8d include an induction coil for forming an induced magnetic field or a gas feeding device for feeding reaction gas to a film forming area.

When the inorganic film is formed in the inorganic film forming chamber 226 by a CCP-CVD method (capacitively coupled plasma CVD), each of the film forming devices 238a to 238d include: a high frequency electrode which is hollow, has a number of pores on a side facing the drum 236 and is connected to a reaction gas resource; and a shower electrode which acts as a reaction gas feeding device.

When the inorganic film 13 is formed in the inorganic film forming chamber 226 by a CVD method, the film forming devices 238a to 238d include a device for introducing reaction gas.

Further, when forming the inorganic film 13 in the inorganic film forming chamber 226 by sputtering, the film forming devices 238a to 238d include: a device for holding a target; a high frequency electrode; and a device for feeding sputter gas.

The vacuum pumping device 244 evacuates the air from the inorganic film forming chamber 226 and sets a degree of vacuum suitable for film forming of the inorganic film 13 by a vacuum film forming method.

The vacuum pumping device 244 is not particularly limited, and known vacuum pumps including a turbo pump, a mechanical booster pump and a rotary pump can be used. Further, other known (vacuum) evacuation devices used for a vacuum film forming apparatus, which is equipped with an auxiliary device such as a cryocoil and a adjustment device for adjusting an achieving vacuum (degree of vacuum) and the evacuation amount, may be used.

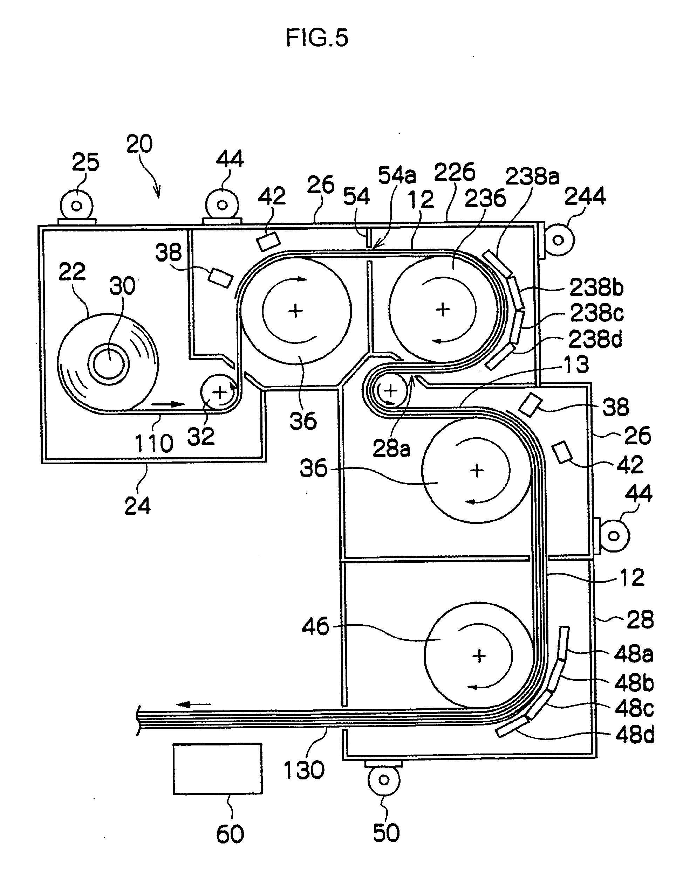

While the method for forming a thin film by laminating a single layer of an organic film or an inorganic film has been described above, the organic film forming chamber 26 and the inorganic film forming chamber 226 may be allowed to intercommunicate together to form a thin film of a double layer as shown in Fig. 5. Furthermore, by combining a plurality of the organic film forming chambers 26 and the inorganic film forming chambers 226, a thin film consisting of more layers may be formed.

The support 110 on which a thin film is formed is then conveyed to the defect cover layer forming chamber 28. In the defect cover layer forming chamber 28, the defect cover layer 130 is formed on the resultant thin film.

The defect cover layer forming chamber 28 may have the same configuration as the inorganic film forming chamber 226. The defect cover layer forming chamber 28 is also a vacuum chamber, and preferably is isolated from adjacent spaces to be substantially airtight. Furthermore, since the defect cover layer 130 is formed by CVD, the film forming devices 48a to 48d include a device for introducing reaction gas or the like.

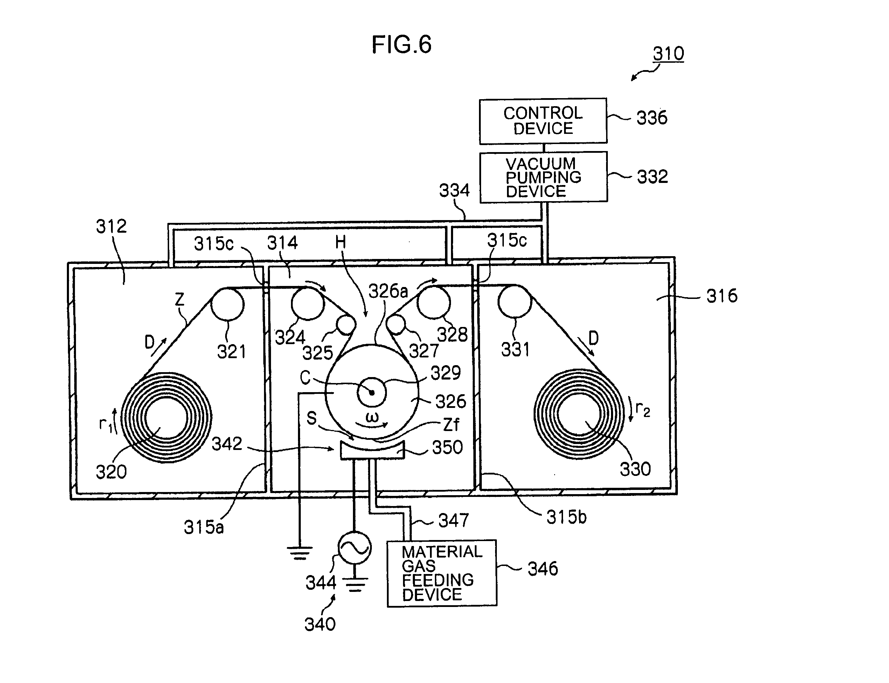

It is preferred that the defect cover layer is formed by CCP-CVD (Capacity Coupled Plasma-CVD) method. Fig. 6 is a diagram of a film forming apparatus for forming the laminate by CCP-CVD method. In Fig. 6, after forming the thin film, the laminate is temporarily wound on a roll, and then the defect cover layer is formed; however, the apparatus shown in Fig. 6 can be provided in place of the defect cover layer forming chamber 28 in the apparatus shown in Figs. 3 to 5.

The film forming apparatus 310 is an apparatus for continuously forming the defect cover layer on the support on which the thin layer is formed. The film forming apparatus 310 includes: a feeding chamber 312 for feeding the support; a film forming chamber 314 for forming the defect cover layer on the thin film; a winding chamber 316 for winding the support on which the defect cover layer is formed on a roll; vacuum pumping device 332; and control device 336. The control device 336 controls each of operation of the film forming apparatus 310. The vacuum pumping device 332 controls vacuum inside of the feeding chamber 312, the film forming chamber 314 and the winding chamber 316 to be predetermined degrees of vacuum, respectively. The achieving degrees of vacuum of the feeding chamber 312, the film forming chamber 314 and the winding chamber 316 by the vacuum pumping device 332 are not particularly limited. It is just needed to keep sufficient degrees of vacuum inside of the feeding chamber 312, the film forming chamber 314 and the winding chamber 316 depending on an adopted film forming method and so on.

The feeding chamber 312 is a member for feeding the support and includes a roll 320 and guide roller 321. The winding chamber 316 is a member for winding up the support on which the defect cover layer is formed, and includes a wind-up roll 330 and a guide roller 331.

The film forming chamber 314 functions as a vacuum chamber and is a member for continuously forming the defect cover layer on the thin film by CCP-CVD method while conveying the support. The film forming chamber 314 is equipped with four guide rollers 324, 325, 327 and 328, drum 326, and film forming device 340.

As shown in Fig. 6, the film forming device 340 is provided below the drum 326 and forms the defect cover layer on the thin film of the support while the drum 326 rotates to convey the support in a conveyance direction D in a state where the support is put on the drum 326. The film forming device 340 includes an electrode for film-forming (film forming electrode) 342, a high-frequency power source 344 and a material gas feeding device 346. The high-frequency power source 344 and the material gas feeding device 346 in the film forming device 340 are connected with the control device 336 and controlled by the device 336.

The film forming electrode 342 is provided in a lower portion of the film forming chamber 314 and is apart from a surface of the drum 326 by a predetermined distance S (space S). The film forming electrode 342 includes a film forming electrode plate 350 and a holding unit for holding the film forming electrode plate 350.

The film forming electrode 342 (film forming electrode plate 350) is connected with the high-frequency power source 344, and the high-frequency power source 344 applies a high-frequency voltage to the film forming electrode plate 350 of the film forming electrode 342. Therefore, an electric filed is generated in the space S between the film forming electrode 342 (film forming electrode plate 350) and the drum 326 within a predetermined range.

The CCP-CVD method enables to form a defect cover layer which is coarser (lower density) than that formed by ICP-CVD method, and such defect cover layer can restrain scattering light from large defects.

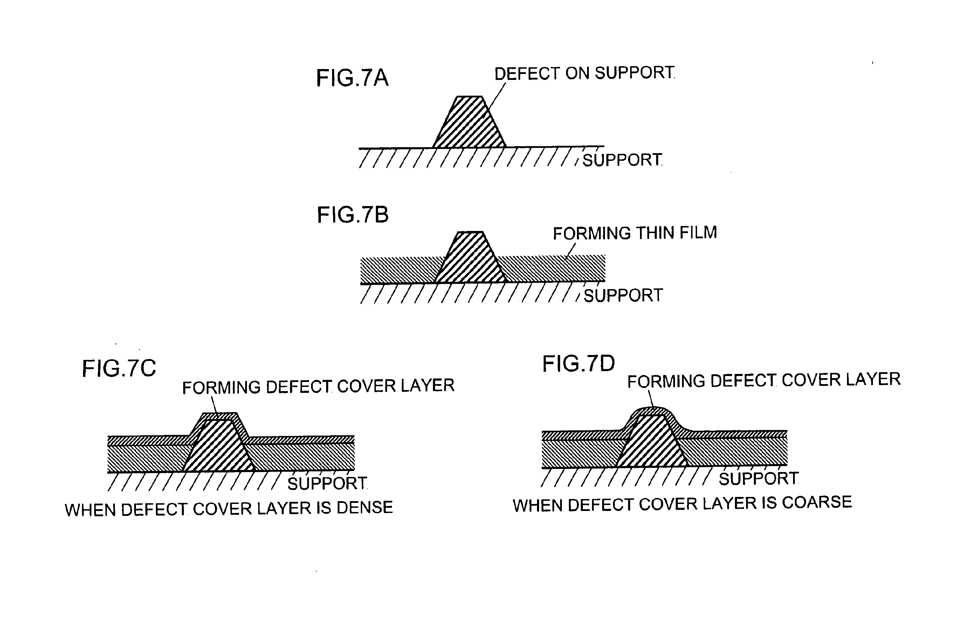

Figs. 7A to 7D illustrate comparison of a state of surface of the defect cover layer when the defect cover layer is dense and when it is coarse. When a large defect is present on a support as shown in Fig. 7A, the large defect still remains on the surface of a thin film after formation of the thin film as shown in Fig. 7B. Then, the defect cover layer is formed on the thin film.

When the defect cover layer is dense (with high density), the shape of the large defect on the surface of the thin film is truly duplicated on the surface of the defect cover layer as shown in Fig. 7C. In other words, the shapes of sharp edges of the large defect are clearly expressed on the surface of the defect cover layer. Such sharp edges of the large defect on the surface contribute to high intensity of scattering light caused by the large defect. Since the dense defect cover layer truly duplicates the shape of the large defect to keep the sharp edges, the intensity of scattering light caused by the large defect remains high. Therefore, since the scattering light caused by large defects blocks scattering light caused by fine defects, the defect cover layer does not effectively work.

On the other hand, when the defect cover layer is coarse (with low density), the shape of the large defect on the surface of the thin film is loosely expressed on the surface of the defect cover layer as shown in Fig. 7D. In other words, the shapes of sharp edges of the large defect become blunt on the surface of the defect cover layer. Since the sharp edges which contribute to high intensity of scattering light caused by the large defect are suppressed by the coarse defect cover layer, the intensity of scattering light caused by the large defect is lowered. Accordingly, it is preferred that the defect cover layer is formed of coarse film.

In addition, when a film-formation rate of the defect cover layer is slower, the defect cover layer tends to be denser. On the other hand, when the film-formation rate is too fast, the defect cover layer is not sufficiently formed, resulting in undesirable consequence. It is preferred that the film-formation rate falls in a range from 200 to 2000 nm/minute, and more preferred, from 300 to 1000 nm/minute.

The laminate produced in this way is inspected by the inspection apparatus 60. In the presently disclosed subject matter, since the defect cover layer 130 is formed by CVD on the uppermost layer, the defect cover layer can cover even large defects. As a result, when inspecting fine defects, it is possible to prevent scattering light caused by the fine defects from being obscured due to scattering light caused by large defects, and therefore such fine defects can be inspected at a high sensitivity. Consequently, a laminate having few fine defects can be produced.

### Examples

Laminates were each produced.

### Laminate 1 (Example 1) Application: UV filter

After forming a layer composed of ZnO with 200 nm thickness on a support by sputtering, a layer (defect cover layer) composed of ZnO with 40 nm thickness was formed at a film-formation rate of 300 nm/minute by CCP-CVD method.

### Laminate 1 (Example 2)

After forming a thin layer in a same manner as Example 1, a defect cover layer was formed at a film-formation rate of 150 nm/minute by ICP-CVD method.

### Laminate 2 (Example 3) Application: gas barrier

After forming a layer composed of DPHA (dipentaerythritol hexaacrylate) with 1000 nm thickness by deposition, a layer (defect cover layer) composed of SiN with 150 nm thickness was formed at a film-formation rate of 500 nm/minute by CCP-CVD method.

### Laminate 3 (Example 4) Application: gas barrier

After forming a layer composed of DPHA with 1000 nm thickness by coating, a layer composed of TiN with 150 nm thickness was formed by sputtering. Further, after forming a layer composed of DPHA with 1000 nm thickness thereon by coating, a layer (defect cover layer) composed of TiN with 150 nm thickness was formed at a film-formation rate of 500 nm/minute by CCP-CVD method.

### Laminate 3 (Example 5)

After forming a thin layer in a same manner as Example 4, a defect cover layer was formed at a film-formation rate of 1000 nm/minute by CCP-CVD method.

### Laminate 3 (Example 6)

After forming a layer composed of DPHA with 1000 nm thickness by coating, a layer composed of TiN with 100 nm thickness was formed by sputtering. Further, after forming a layer composed of DPHA with 1000 nm thickness thereon by coating, a layer (defect cover layer) composed of TiN with 150 nm thickness was formed at a film-formation rate of 200 nm/minute by CCP-CVD method.

### Laminate 3 (Example 7)

After forming a layer composed of DPHA with 1000 nm thickness by coating, a layer composed of TiN with 200 nm thickness was formed by sputtering. Further, after forming a layer composed of DPHA with 1000 nm thickness thereon by coating, a layer (defect cover layer) composed of TiN with 150 nm thickness was formed at a film-formation rate of 2000 nm/minute by CCP-CVD method.

In addition, as Comparative Examples 1 to 3, laminates were produced by the same process as in each Example except for forming the defect cover layers of Examples 1, 3 and 4 by sputtering.

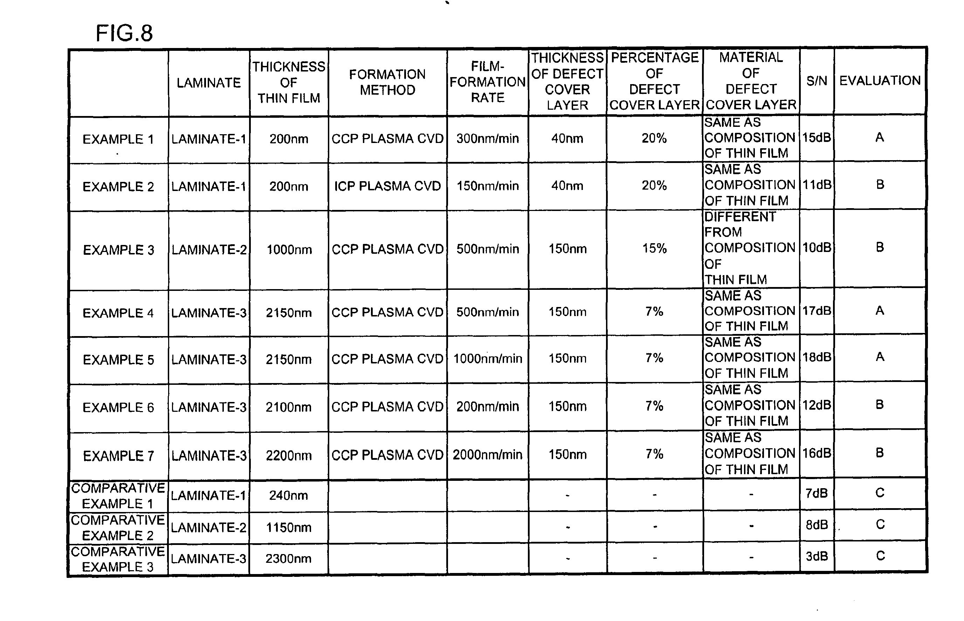

The resulting laminates were irradiated with halogen light, and with shifting the axis of reflecting light, the S/N (Signal to Noise ratio) for defects having 1.0 µm size was measured by line CCD. A laminate having an S/N of 10 dB or more was rated as good "B," a laminate having a S/N of 15 dB or more was rated as excellent "A" and a laminate having a S/N less than 15 dB was rated as poor "C". Results are shown in Fig. 8.

Forming a defect cover layer has led to production of a quality laminate having a high S/N and fewer defects. When the defect cover layers are formed by CCP-CVD method, laminates with fewer defects are produced compared to those produced by ICP-CVD method. Further, it is recognized that the preferred film-formation rate falls in a range from 200 to 2000 nm/minute, and more preferred, from 300 to 1000 nm/ minute in order to produce quality laminates. In addition, forming a defect cover layer from a material having the same composition as that of any layer in thin film has made it possible to produce a good laminate.

## Claims

1. A method for producing a laminate, comprising:
a film forming step of forming a thin film (120, 160) having one or more layers on a support (110);
a defect cover layer forming step of forming by CVD a further layer (130, 170) being a defect cover layer, on the thin film and
an inspection step of detecting a defect (180) in the surface of the thin film covered with the defect cover layer
by irradiating the thin film with light through the top of the defect cover layer (130, 170) and detecting scattered light from the defect; the defect having a size of 0.1 µm or more and 20 µm or less

2. The method for producing a laminate according to claim 1, wherein the defect cover layer (130, 170) has the same composition as any one of the one or more layers of the thin film (120, 160) formed on the support (110).

3. The method for producing a laminate according to claim 1 or 2, wherein the defect cover layer (130, 170) is 0.3 times or less as thick as the thin film (120, 160).

## Patentansprüche

1. Verfahren zur Herstellung eines Laminats, umfassend:
einen Filmausbildungsschritt zum Ausbilden eines Dünnfilms (120, 160) mit einer oder mehreren Schichten auf einem Träger (110);
einen Defektdeckschichtausbildungsschritt zum Ausbilden einer weiteren Schicht (130, 170), die eine Defektdeckschicht ist, auf dem Dünnfilm mittels chemischer Gasphasenabscheidung; und
einen Inspektionsschritt zum Erkennen eines Defekts (180) in der Fläche des Dünnfilms, der mit der Defektdeckschicht bedeckt ist, indem der Dünnfilm mit Licht durch die Oberseite der Defektdeckschicht (130, 170) bestrahlt wird und gestreutes Licht von dem Defekt detektiert wird, wobei der Defekt eine Größe von 0,1 µm oder mehr und 20 µm oder weniger aufweist.

2. Verfahren zur Herstellung eines Laminats nach Anspruch 1, bei dem die Defektdeckschicht (130, 170) die gleiche Zusammensetzung wie eine Beliebige der einen oder mehreren Schichten des Dünnfilms (120, 160), der auf dem Träger (110) ausgebildet ist, aufweist.

3. Verfahren zur Herstellung eines Laminats nach Anspruch 1 oder 2, bei dem die Defektdeckschicht (130, 170) 0,3 Mal oder weniger so dick wie der Dünnfilm (120, 160) ist.

## Revendications

1. Procédé pour la production d'un stratifié, comprenant :
un étape de formation de film qui consiste à former un film mince (120, 160) ayant une ou plusieurs couche(s) sur un support (110) ;
une étape de formation de couche de couverture de défaut qui consiste à former par dépôt chimique en phase vapeur une couche supplémentaire (130, 170) étant une couche de couverture de défaut, sur le film mince ; et
une étape d'inspection qui consiste à détecter un défaut (180) dans la surface du film mince recouverte par la couche de couverture de défaut en irradiant le film mince avec une lumière à travers la partie supérieure de la couche de couverture de défaut (130, 170) et en détectant la lumière diffusée par le défaut ; le défaut ayant une taille supérieure ou égale à 0,1 µm et inférieure ou égale à 20 µm.

2. Procédé pour la production d'un stratifié selon la revendication 1, dans lequel la couche de couverture de défaut (130, 170) a la même composition que l'une quelconque de la ou des couche(s) du film mince (120, 160) formée(s) sur le support (110).

3. Procédé pour la production d'un stratifié selon la revendication 1 ou 2, dans lequel la couche de couverture de défaut (130, 170) est 0,3 fois ou moins aussi épaisse que le film mince (120, 160).
